# EUROPÄISCHE PATENTSCHRIFT

(11) **EP 1 577 964 B1**
(45) Veröffentlichungstag und Bekanntmachung des Hinweises auf die Patenterteilung: **14.10.2009**
(21) Anmeldenummer: 04090102.7
(22) Anmeldetag: 11.03.2004
(51) Int. Cl.: H01L 51/10

(54) **Verfahren zur Herstellung eines organischen, vertikalen Feldeffekttransistors**
Method for the production of an organic vertical field effect transistor
Procédé de production d'un transistor organique vertical à effet de champ

(43) Veröffentlichungstag der Anmeldung: 21.09.2005
(73) Patentinhaber: Samsung Mobile Display Co., Ltd., Suwon-si Gyeonggi-do (KR)
(72) Erfinder: Redecker, Michael Dr., 12305 Berlin (DE); Fischer, Joerg, 13053 Berlin (DE); Mathea, Arthur, 14197 Berlin (DE)
(74) Vertreter: Hengelhaupt, Jürgen

(56) Entgegenhaltungen:
- EP-A- 1 265 103
- EP-A- 1 281 666
- WO-A-02/29912
- US-A- 5 676 853
- US-A1- 2001 014 426
- US-A1- 2002 121 662
- FEDYNYSHYN T H ET AL: "Encapsulated inorganic resist technology applied to 157 nm-lithography" PROC. SPIE - INT. SOC. OPT. ENG. (USA), PROCEEDINGS OF THE SPIE - THE INTERNATIONAL SOCIETY FOR OPTICAL ENGINEERING, 2001, SPIE-INT. SOC. OPT. ENG, USA, Bd. 4345, pt.1-2, August 2001 (2001-08), Seiten 308-318, XP002291823 ISSN: 0277-786X

## Beschreibung

Die Erfindung betrifft ein Verfahren zur Herstellung eines organischen, vertikalen Feldeffekttransistors mit den im Oberbegriff des Anspruchs 1 genannten Merkmalen.

Unter dem Oberbegriff der organischen Elektronik sind neben Anwendungen im Bereich der Displayelemente, z.B. der organischen Leuchtdioden, auch Feldeffekttransistoren als Anwendung diskutiert worden. Diese bilden ein weiteres Glied hin zur Realisierung von einfachen elektronischen Schaltungen, die ohne aufwendige Halbleiter-Fabrikationsprozesse hergestellt werden können. Unter anderem können die so hergestellten Schaltungen auf der Basis organischer und polymerer Halbleiter für Transponder-Anwendungen sowie zur Ansteuerung von großflächigen Displays verwendet werden.

Bei einer auf organischem Material basierenden Feldeffekttransistorstruktur ist halbleitendes, organisches Material zwischen einer Sourceelektrode und einer Drainelektrode angeordnet. Im Bereich (Kanal) zwischen diesen beiden Elektroden wird durch Anlegen einer geeigneten Spannung an der Gateelektrode ein elektrisches Feld erzeugt, wodurch Ladungsträger (Elektronen oder Defektelektronen) in den aus organischem Material bestehenden Kanal eingebracht werden und dort die Leitfähigkeit zwischen Source- und Drainkontakt erhöhen. Dabei wird die Leitung im Kanal bei einer Transistorstruktur mit p-Charakteristik durch Defektelektronen (Löcher), bei einer Transistorstruktur mit n-Charakteristik durch Elektronen realisiert. Der Transistor kann somit durch die Gatespannung gesteuert werden.

Um eine Migration der Gegenladungen von der Gateelektrode in den Kanal zu vermeiden, wodurch das elektrische Feld und damit die Funktionalität der Transistorstruktur abnehmen würde, ist es bekannt, zwischen Kanal und Gateelektrode eine Ladungsträger-Sperrschicht (Dielektrikum) anzuordnen.

Nachteilig an den bekannten organischen Transistorstrukturen ist jedoch deren niedriger maximal erreichbarer Strom. Der maximal erreichbare Strom ist jedoch für die Anwendbarkeit organischer Transistoren, z.B. für Aktiv-Matrix-OLED-Displays von entscheidender Bedeutung.

Der erreichbare Strom hängt unter anderem von der Länge und der Breite des leitfähigen (aus organischem, halbleitendem Material bestehenden) Kanals sowie von der Beweglichkeit der Ladungsträger im organischen Halbleiter ab. Typische organische Materialien sind niedermolekulare Verbindungen wie Pentacen, Tetracen, Oligothiophene als p-Halbleiter sowie Derivate von Napthalintetracarbonsäurediimid sowie Perylentetracarbonsäurediimid als n-Halbleiter. Als polymere Materialien kommen insbesondere p-Halbleiter wie Polyalkylthiophene sowie Copolymere von Alkylthiophenen mit Alkylfluoreneinheiten in Frage.

Zur Erzielung eines maximalen Stroms sollte die Kanallänge klein sein, während die Kanalbreite und die Beweglichkeit hoch sein müssen. Einen weiteren Aspekt stellt die aufgebrachte Dicke des organischen Halbleiters dar, die damit die Kanaldicke definiert. Der für die Modulation des Stromes zwischen Sourceelektrode und Drainelektrode genutzte Kanal verläuft in einer sehr dünnen Schicht nahe an der Ladungsträger-Sperrschicht (Dielektrikum). Eine große Materialdicke für den organischen Halbleiter ist deshalb nicht erforderlich. Im Gegenteil führt eine Erhöhung der Dicke des Halbleiters zur Verschlechterung des Verhältnisses aus dem Strom im angeschalteten bzw. im ausgeschalteten Zustand. Aus der Literatur ist bekannt, dass optimale Schichtdicken im Bereich unter 100 Nanometern liegen.

Organische Halbleiter sind in ihrer Ladungsträgerbeweglichkeit den anorganischen Materialien wie z.B. Silizium weit unterlegen. Typische Beweglichkeiten liegen im Bereich von 10⁻² bis 1 cm²/Vs. Zur Erzielung eines hohen, maximal erreichbaren Stroms ist es deshalb nötig, die geringe Ladungsträgerbeweglichkeit durch eine geringe Kanallänge auszugleichen. Typische Kanallängen für organische Feldeffekttransistoren liegen im Bereich von 5-100 Mikrometern. Eine Reduzierung unter 5 Mikrometer beinhaltet im allgemeinen die Anwendung von hochauflösenden Verfahren der Photolithographie, die kostenintensiv sind und die Prozessvorteile der organischen Elektronik gegenüber traditioneller Halbleitertechnik vermindern.

Zur weiteren Verringerung der Kanallänge (zur Erzielung hoher Ströme) bei gleichzeitiger Vermeidung von kostenintensiven Prozessen wie der Photolithographie (zur hochauflösenden lateralen Strukturierung) ist es aus Kudo et al, Thin solid films, Vol 331 (1998), pp 51-54 und Stutzmann et al, Science Vol 299 (2003), pp 1881-1884 bekannt, Sourceelektrode und Drainelektrode eines organischen Feldeffekttransistors auf einem Substrat nicht nebeneinander, sondern übereinander aufzubringen. Dabei handelt es sich um den sog. vertikalen Feldeffektransistor, der auch unter dem Begriff "Static Induction Transistor" (SIT) beschrieben wird.

Der Kanal, also das zwischen Sourceelektrode und Drainelektrode angeordnete organische Material, durch welches der Stromfluss des Transistors erfolgt, ist in Bezug auf das Substrat vertikal angeordnet. Die Kanallänge wird nur durch die Dicke der Halbleiterschicht limitiert. Durch Schichtabscheidung von niedermolekularen organischen Halbleitern im Hochvakuum ebenso wie durch Aufschleudern von polymeren Materialien können so problemlos Schichtdicken im Bereich von wenigen zehn Nanometern bis hin zu Mikrometern erreicht werden, wodurch die Kanallänge im Vergleich zu nicht vertikalen organischen Feldeffekttransistoren - bei Vermeidung von kostenintensiver Photolithographie - deutlich reduziert und damit der maximal schaltbare Strom erhöht werden kann.

Da jedoch Sourceelektrode und Drainelektrode nicht nebeneinander auf dem Substrat, sondern übereinander angeordnet sind, kann die Gateelektrode zur Steuerung des Transistors nicht mehr als kontinuierliche Schicht auf das organische Material aufgebracht werden, da sie sonst den Fluß der Ladungsträger von der Sourceelektrode zur Drainelektrode unterbrechen würde. Aus Kudo et al. ist es bekannt, eine dünne Aluminiumschicht als Gateelektrode zu verwenden, welche nicht kontinuierlich, sondern in Inseln gewachsen ist. Die Zwischenräume der nicht kontinuierlichen Gateelektrode fungieren als Kanäle. Durch Zuführen von Luft bildet sich auf der Metalloberfläche das entsprechende Oxid, das als Ladungsträger-Sperrschicht (Dielektrikum) wirkt. Die Herstellung einer reproduzierbaren Netzstruktur mittels dieser Methode ist jedoch kritisch. Insbesondere ist ein großer Leckstrom von der Gateelektrode zur Sourceelektrode zu beobachten, welcher den Vorteil der leistungslosen Steuerung von Feldeffekttransistoren mindert. Nach Stutzmann et al. wird die Gate-Region durch einen mechanischen Mikroschnitt definiert, wonach die Ladungsträger-Sperrschicht (Dielektrikum) sowie die Gateelektrode aufgebracht werden. Neben der Reproduzierbarkeit des Verfahrens ist hier auch die Kanaldicke kritisch. Sie ist vorgegeben durch den Überlapp von Sourceelektrode und Drainelektrode und beträgt im besten Falle mehr als 10 Mikrometer. Zudem wird nur ein kleiner Teil der Transistorfläche für den Kanal genutzt. Vorzugsweise sollte ein großer Anteil der Fläche ausgenutzt werden, um selbst bei kleinen Transistordimensionen einen großen Strom erzielen zu können.

WO 02/29912 offenbart Verfahren zur Herstellung eines vertikalen Feldeffekttransistor mit folgenden Schritten: Aufbringen einer ersten Elektrode auf ein Substrat, Aufbringen einer Isolierschicht, Aufbringen einer nichtkontinuierlichen Gateelektrode mit Ladungsträger-Sperrschicht, Aufbringen von organischem, halbleitenden Material und Aufbringen einer zweiten Elektrode.

T.H. Fedynyshyn et al., Proc. SPIE - Int. Soc. Opt. Eng. (USA), Bd. 4345, (08.2001) Sn. 308-318 offenbart ein Verfahren zur Strukturierung von Schichten mittels Halbleiter-Lithographie, bei dem SiO₂-Nanopartikel zu organischen, polymeren Photolacken zugesetzt wurden.

Es ist Aufgabe der vorliegenden Erfindung, ein Verfahren zur Herstellung eines vertikalen, organischen Feldeffekttransistors anzugeben, welches eine bessere Reproduzierbarkeit als die bekannten Verfahren nach dem Stand der Technik aufweist und zudem kostengünstiger ist. Insbesondere soll die Verwendung von Photolithographie und Schattenmasken vermieden werden.

Diese Aufgaben werden erfindungsgemäß gelöst durch die Merkmale im kennzeichnenden Teil des Anspruchs 1 (Verfahrensanspruch) im Zusammenwirken mit den Merkmalen im Oberbegriff. Bevorzugte Ausgestaltungen der Erfindung sind in den Unteransprüchen enthalten.

Dazu ist es erfindungsgemäß vorgesehen, die Strukturierung der Gateelektrode durch Verwendung von Nanopartikeln vorzunehmen. Die mittels Nanopartikeln erzeugten Gateelektrodenstrukturen weisen die erforderlichen Mikroporositäten auf, wodurch eine kostenintensive Strukturierung mittels Masken oder anderer hochauflösender Strukturierungsprozesse vermieden werden kann. Durch die Verwendung von Nanopartikel bzw. mikroskopischem Materialcomposit kann eine Vielzahl von identischen bzw. ähnlichen Strukturen erzeugt werden, die mittels ausreichender Statistik die erforderlichen Gesamteigenschaften liefern. Eine gezielte Strukturierung ist dann nur noch auf niedrig aufgelöster Ebene, z.B. zur Definition der Flächen von Source, Drain und Gate nötig. Insbesondere durch die Vermeidung von Feinstrukturierungsmethoden, wie z.B. der Photolithographie, weist das erfindungsgemäße Verfahren gegenüber dem bekannten Verfahren einen Kostenvorteil auf.

Zur Herstellung eines vertikalen Feldeffekttransistors wird erfindungsgemäß eine Sourceelektrode auf ein Substrat aufgebracht, danach eine Hilfsisolatorschicht sowie eine nichtkontinuierliche Gateelektrode mit Ladungsträger-Sperrschicht aufgebracht, wobei die Strukturierung der Gateelektrode durch Verwendung von Nanopartikel vorgenommen wird; nachfolgend werden organisches, halbleitendes Material (Kanal) und eine Drainelektrode aufgebracht. Alternativ ist jedoch auch möglich, zuerst die Drainelektrode auf ein Substrat aufzubringen, danach eine Hilfsisolatorschicht sowie eine nichtkontinuierliche Gateelektrode mit Ladungsträger-Sperrschicht aufzubringen, nachfolgend organisches, halbleitendes Material (Kanal) und eine Sourceelektrode aufzubringen.

Erfindungsgemäß ist es vorgesehen, zum Aufbringen der nicht kontinuierlichen Gateelektrode dispergierte, metallische Nanopartikel in einer dielektrischen Matrix aufzubringen und das dielektrische Material selektiv zu ätzen. Dabei wird die dielektrische Matrix mit den dispergierten metallischen Nanopartikeln, vorzugsweise mittels Coverdampfung von Metallpartikeln und dielektrischem Material erzeugt. Geeignete Materialkombinationen für Nanopartikel/dielektrisches Material sind Cr/SiOx sowie Al/SiOx.

Die Ladungsträger-Sperrschicht wird vorzugsweise nach Ausbildung der nichtkontinuierlichen Gateelektrode durch thermische Oxidation, Plasmaoxidation und/oder Anodisieren der nichtkontinuierlichen Gateelektrode erzeugt. Die Sourceelektrode wird vorzugsweise mittels Aufdampfen im Hochvakuum oder Sputtern, das organische Material vorzugsweise mittels Aufdampfen im Hochvakuum oder Aufschleudern aus einer Lösung und die Drainelektrode mittels Aufdampfen im Hochvakuum oder Sputtern aufgebracht. Die Hilfsisolatorschicht wird aus einem dielektrischen Material mittels Aufdampfen im Hochvakuum, Sputtern oder Chemical Vapour Deposition auf die Sourceelektrode aufgebracht. Durch die Hilfsisolatorschicht wird insbesondere ein elektrischer Kontakt zwischen Sourceelektrode und Gateelektrode effektiv vermieden werden. Vorzugsweise werden Nanopartikel einer Größe von 50 nm bis 3 µm verwendet.

Die Erfindung wird nachfolgend anhand von Ausführungsbeispielen näher erläutert. Es zeigen:
- Figur 1: einen herkömmlichen organischen Feldeffekttransistor in schematischer, geschnittener Darstellung,
- Figur 2: einen vertikalen organischen Feldeffekttransistor in schematischer, geschnittener Darstellung, und
- Figur 3a bis 3d: die einzelnen Schritte zur Herstellung eines organischen Feldeffekttransistors nach dem erfindungsgemäßen Verfahren.

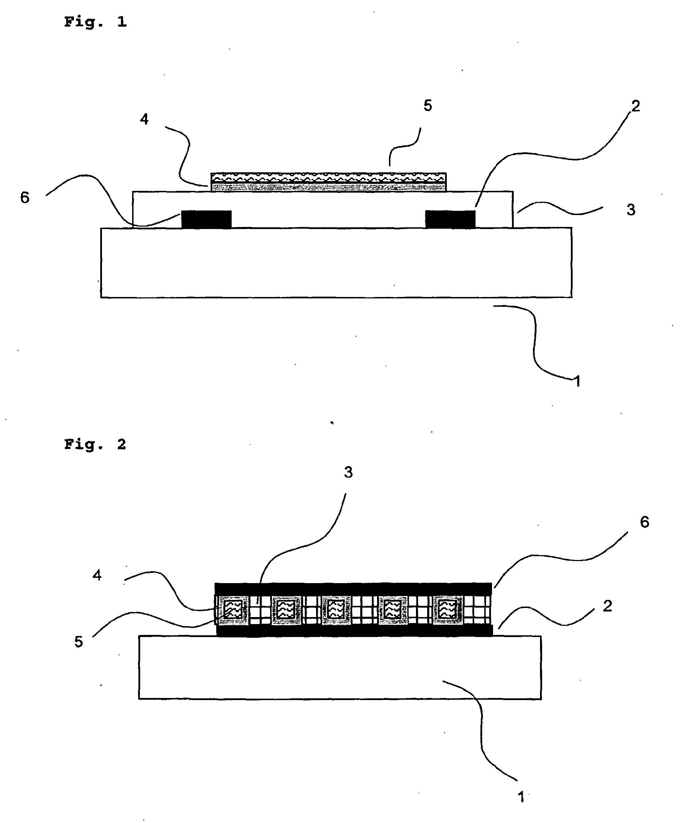

Fig. 1 zeigt einen herkömmlichen organischen Feldeffekttransistor in schematischer, geschnittener Darstellung. Bei diesem Feldeffekttransistor sind die Sourceelektrode 2 und die Drainelektrode 6 nebeneinander auf dem Substrat 1 angeordnet. Darüber ist die Gateelektrode 5 (mit Ladungsträger-Sperrschicht 4) angeordnet, wobei durch die an der Gateelektrode 5 angelegte Spannung der Stromfluss zwischen Sourceelektrode 2 und die Drainelektrode 6 gesteuert werden kann. Durch den Abstand von Sourceelektrode 2 und Drainelektrode 6 wird die Länge des aus organischem, halbleitenden Material 3 bestehenden Kanals 3 definiert. Zur Erzielung hoher Ströme ist eine geringe Kanallänge erforderlich, welche bei herkömmlichen organischen Feldeffekttransistoren nur durch den Einsatz von kostenintensiven, hochauflösenden Verfahren wie der Photolithographie auf weniger als 5 µm reduziert werden kann.

Fig. 2 zeigt einen vertikalen organischen Feldeffekttransistor, bei welchem im Gegensatz zu herkömmlichen organischen Feldeffekttransistoren Sourceelektrode 2 und Drainelektrode 6 übereinander auf dem Substrat 1 angeordnet sind. Hierdurch ist eine geringe Kanallänge (im Nanometerbereich) des organischen Materials 3, welche der Schichtdicke des organischen Materials 3 entspricht, realisierbar. Jedoch muss die Gateelektrode 5 im Gegensatz zu herkömmlichen Feldeffekttransistoren nicht-kontinuierlich bzw. porös ausgebildet sein.

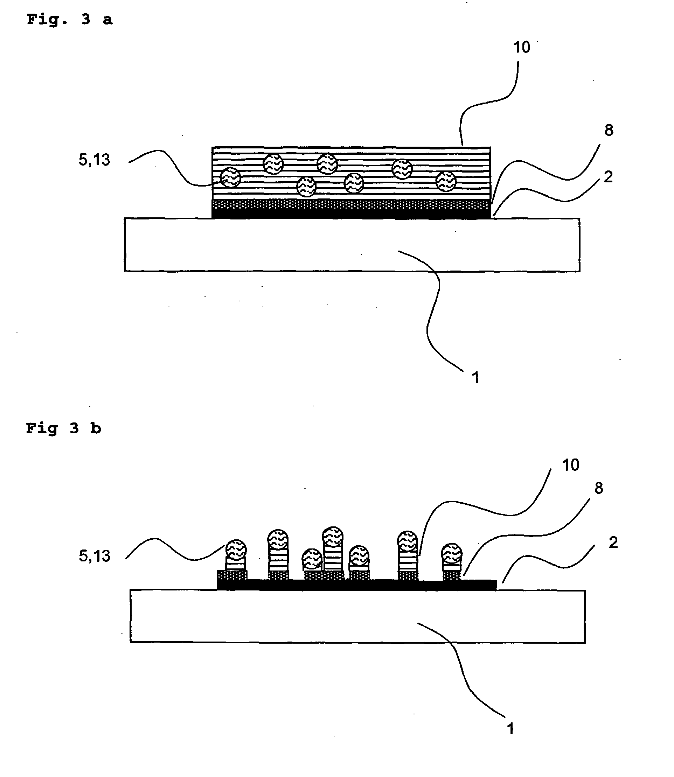

Nachfolgend wird anhand der Figuren 3a bis 3d die Herstellung eines vertikalen organischen Feldeffekttransistors (mit nicht kontinuierlicher Gateelektrode) nach der ersten bevorzugten Ausführungsvariante des erfindungsgemäßen Verfahrens beschrieben.

Auf ein geeignetes Substrat 1, z.B. Glas, Silizium oder eine flexible Trägerfolie, wird die Sourceelektrode 2 aufgebracht. Geeignete Verfahren sind u.A. Aufdampfen im Hochvakuum sowie Sputtern. Geeignete Materialien sind edle Metalle wie Gold, Palladium, Platin und Nickel sowie Indium-Zinnoxid. Auf die Sourceelektrode 2 wird mittels Aufdampfen im Hochvakuum, Sputtern oder CVD (Chemical Vapour Deposition) eine Isolierschicht 8 (Dielektrikum) aufgebracht. Geeignete Materialien für die Isolierschicht 8 sind unter anderem SiO₂, SiOₓ, Si₃N₄, SiₓO_{y}. Auf diese Schicht 8 folgt die eigentliche Funktionsschicht, die aus in einer dielektrischen Matrix 10 dispergierten metallischen Nanopartikeln 13 besteht, welche später die Gateelektrode 5 ausbilden. Diese Schicht kann durch Coverdampfung eines geeigneten Metalls 5 und einem Dielektrikum 10 hergestellt werden. Geeignete Metalle für die Nanopartikel 13 sind u.A. Al, Ti, Ta, Zr, Hf, Cr. Als dielektrische Matrix 10 kommt insbesondere SiOₓ in Frage.

Durch geeignete anisotrope Ätzprozesse wird die in Fig. 3b gezeigte Struktur hergestellt. Der Ätzprozess muss selektiv das Dielektrikum der Matrix 10 sowie die darunter liegende Isolierschicht 8 entfernen, während das Material von Source- und Gatekontakt 2, 5 nicht angegriffen wird. Im Falle von SiOₓ als Dielektrikum 10 eignen sich Plasmaätzprozesse mit fluorhaltigen Ätzgasen wie CF₄, CF₃H, C₄H₉, C₂F₆, SF₆ und NF₃.

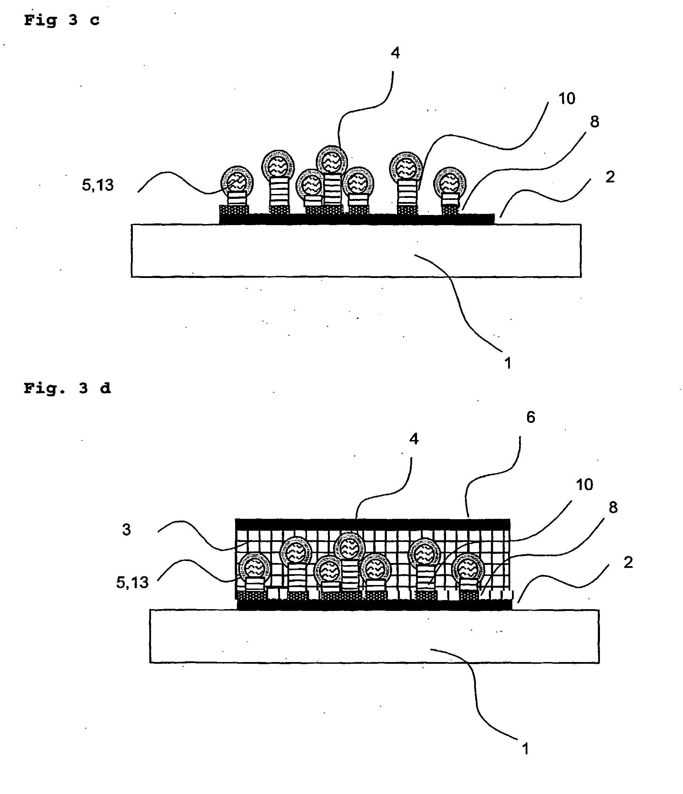

Durch Oxidation wird auf dem Gate-Metall 5 die Ladungsträger-Sperrschicht 4 (Dielektrikum) gebildet, wie in Fig 3c dargestellt ist. Geeignete Prozesse umfassen thermische Oxidation, Plasmaoxidation sowie Anodisieren. Schließlich wird der organische Halbleiter 3 entweder durch Aufdampfen im Hochvakuum oder durch Aufschleudern aus einer Lösung aufgebracht. Die Struktur wird vervollständigt durch Aufbringen des Drainkontakts 6 mittels Aufdampfen im Hochvakuum oder durch Sputtern. Geeignete Materialien für den Drainkontakt 6 sind Gold, Palladium, Platin und Nickel sowie Indium-Zinnoxid.

Bei der so hergestellten Transistorstruktur (Fig. 3d) besteht die Gateelektrode 5 aus Metalldomänen (Nanopartikel 13), welche untereinander in leitender Verbindung stehen und auf der Oberfläche mit einer Oxidschicht (Ladungsträger-Sperrschicht 4) belegt sind, die als Dielektrikum fungiert. Die Zwischenräume sind mit organischem Halbleiter 3 gefüllt. Durch die Ausbildung eines Netzwerkes aus Metalldomänen kann die Gateelektrode 5 von außen kontaktiert werden.

## Patentansprüche

1. Verfahren zur Herstellung eines vertikalen Feldeffekttransistor mit folgenden Schritten:
- Aufbringen einer ersten Elektrode (2) auf ein Substrat (1),
- Aufbringen einer Isolierschicht (8),
- Aufbringen einer nichtkontinuierlichen Gateelektrode (5) mit Ladungsträger-Sperrschicht (4),
- Aufbringen von organischem, halbleitenden Material (3) und
- Aufbringen einer zweiten Elektrode (6),
wobei die Gateelektrode (5) durch Nanopartikel (13) ausgebildet wird,
**dadurch gekennzeichnet, dass**
zum Aufbringen der nichtkontinuierlichen Gateelektrode (5) dispergierte, metallische Nanopartikel (13) in einer dielektrischen Matrix (10) aufgebracht werden und das dielektrische Material (10) selektiv zu den metallischen Nanopartikeln geätzt wird, wobei das dielektrische Material (10) und die darunter liegende Isolierschicht (8) selektiv entfernt werden.

2. Verfahren nach Anspruch 1,
**dadurch gekennzeichnet, dass**
als erste Elektrode die Sourceelektrode (2) und als zweite Elektrode die Drainelektrode (6) aufgebracht wird.

3. Verfahren nach Anspruch 1,
**dadurch gekennzeichnet, dass**
dass für die Nanopartikel Chrom oder Aluminium und für die dielektrische Matrix SiOx verwendet wird.

4. Verfahren nach Anspruch 1,
**dadurch gekennzeichnet, dass**
die dielektrische Matrix mit den dispergierten, metallischen Nanopartikel mittels Coverdampfung von Metallpartikeln und dielektrischem Material erzeugt werden.

5. Verfahren nach einem der vorhergehenden Ansprüche,
**dadurch gekennzeichnet, dass**
die Ladungsträger-Sperrschicht (4) durch thermische Oxidation, Plasmaoxidation und/oder Anodisieren der nichtkontinuierlichen Gateelektrode (5) erzeugt wird.

6. Verfahren nach einem der Ansprüche 2-5,
**dadurch gekennzeichnet, dass**
die Sourceelektrode (2) mittels Aufdampfen im Hochvakuum oder Sputtern, das organische Material (3) mittels Aufdampfen im Hochvakuum oder Aufschleudern aus einer Lösung und die Drainelektrode (6) mittels Aufdampfen im Hochvakuum oder Sputtern aufgebracht werden.

7. Verfahren nach einem der vorhergehenden Ansprüche,
**dadurch gekennzeichnet, dass**
die Isolierschicht (8) aus einem dielektrischen Material mittels Aufdampfen im Hochvakuum, Sputtern oder Chemical Vapour Deposition aufgebracht wird.

## Claims

1. Method for the manufacture of a vertical field-effect transistor with the following steps:
- Applying a first electrode (2) onto a substrate (1),
- Applying an insulating layer (8),
- Applying a non-continuous gate electrode (5) having a charge carrier blocking layer (4),
- Applying an organic semi-conducting material (3) and
- Applying a second electrode (6),
wherein the gate electrode (5) is formed of nanoparticles (13),
**characterized in that**
for the purpose of applying the non-continuous gate electrode (5), dispersed metallic nanoparticles (13) are deposited in a dielectric matrix (10) and the dielectric material (10) is selectively etched with respect to the metallic nanoparticles, wherein the dielectric material (10) and the insulating layer (8), which is underlying the dielectric material (10), are selectively removed.

2. Method according to claim 1,
**wherein**
the source electrode (2) is applied as a first electrode, and the drain electrode (6) is applied as a second electrode.

3. Method according to claim 1,
**wherein**
chrome or aluminium is used for the nanoparticles, and SiOx is used for the dielectric matrix.

4. Method according to claim 1,
**wherein**
the dielectric matrix with the dispersed metallic nanoparticles is manufactured by means of co-evaporation of metal particles and dielectric material.

5. Method according to one of the previous claims,
**wherein**
the charge carrier blocking layer (4) is manufactured by thermal oxidation, plasma oxidation and/or anodising of the non-continuous gate electrode (5).

6. Method according to one of the claims 2-5,
**wherein**
the source electrode (2) is applied by means of high-vacuum vapour deposition or sputtering, the organic material (3) is applied by means of high-vacuum vapour deposition or spin coating from a solution, and the drain electrode (6) is applied by means of high-vacuum vapour deposition or sputtering.

7. Method according to one of the previous claims,
**wherein**
the insulating layer (8) consisting of a dielectric material is applied by means of high-vacuum vapour deposition, sputtering or chemical vapour deposition.

## Revendications

1. Procédé pour fabriquer un transistor à effet de champ vertical comprenant les étapes suivantes :
- application d'une première électrode (2) sur un substrat (1),
- application d'une couche isolante (8),
- application d'une électrode à grille (5) non continue avec une couche de blocage à support de charge (4),
- application de matériau (3) organique et semi-conducteur et
- application d'une seconde électrode (6),
l'électrode à grille (5) étant réalisée par des nanoparticules (13),
**caractérisé en ce que**
des nanoparticules (13) métalliques et dispersées sont appliquées dans une matrice (10) diélectrique pour l'application de l'électrode à grille (5) non continue et le matériau (10) diélectrique est décapé de façon sélective pour former les nanoparticules métalliques, le matériau (10) diélectrique et la couche isolante (8) sous-jacente étant enlevés de façon sélective.

2. Procédé selon la revendication 1,
**caractérisé en ce que**
l'électrode de source (2) est appliquée comme première électrode et l'électrode de drain (6) comme seconde électrode.

3. Procédé selon la revendication 1,
**caractérisé en ce que**
on utilise du chrome ou de l'aluminium pour les nanoparticules et du SiOx pour la matrice diélectrique.

4. Procédé selon la revendication 1,
**caractérisé en ce que**
la matrice diélectrique est générée avec les nanoparticules dispersées et métalliques au moyen d'une co-évaporation de particules métalliques et de matériau diélectrique.

5. Procédé selon l'une quelconque des revendications précédentes,
**caractérisé en ce que**
la couche de blocage à support de charge (4) est générée par oxydation thermique, plasmaoxydation et/ou anodisation de l'électrode à grille (5) non continue.

6. Procédé selon l'une quelconque des revendications 2 à 5,
**caractérisé en ce que**
l'électrode de source (2) est appliquée par métallisation dans du vide élevé ou métallisation cathodique, le matériau (3) organique par métallisation sous vide élevé ou projection à partir d'une solution et l'électrode de drain (6) par métallisation sous vide élevé ou pulvérisation.

7. Procédé selon l'une quelconque des revendications précédentes,
**caractérisé en ce que**
la couche isolante (8) à base d'un matériau diélectrique est appliquée par métallisation sous vide élevé, pulvérisation ou dépôt chimique en phase vapeur.
